# EUROPÄISCHE PATENTSCHRIFT

(11) **EP 2 998 777 B1**
(45) Veröffentlichungstag und Bekanntmachung des Hinweises auf die Patenterteilung: **22.02.2023**
(21) Anmeldenummer: 15183676.4
(22) Anmeldetag: 03.09.2015
(51) Int. Cl.: G02B 26/08, B81B 3/00, H01L 41/00

(54) **PIEZOELEKTRISCHER POSITIONSSENSOR FÜR PIEZOELEKTRISCH ANGETRIEBENE RESONANTE MIKROSPIEGEL**
PIEZOELECTRIC POSITION SENSOR FOR PIEZOELECTRIC DRIVEN RESONANT MICROMIRROR
CAPTEUR DE POSITION PIEZOELECTRIQUE POUR MICRO-MIROIR A RESONANCE ENTRAINE PIEZO-ELECTRIQUEMENT

(30) Priorität: 05.09.2014 DE 102014217799
(43) Veröffentlichungstag der Anmeldung: 23.03.2016
(73) Patentinhaber: Fraunhofer-Gesellschaft zur Förderung der angewandten Forschung e.V., 80686 München (DE)
(72) Erfinder: GU-STOPPEL, Shanshan, 25524 Itzehoe (DE); QUENZER, Hans-Joachim, 25524 Itzehoe (DE); JANES, Joachim, 25524 Itzhoe (DE); HEINRICH, Felix, 25355 Barmstedt (DE)
(74) Vertreter: Zimmermann, Tankred Klaus

(56) Entgegenhaltungen:
- WO-A1-2011/122410
- DE-C1- 19 857 946
- US-A1- 2009 185 253
- US-A1- 2010 097 681
- US-A1- 2011 063 702
- BARAN UTKU ET AL: "Resonant PZT MEMS scanners with integrated angle sensors", 2013 INTERNATIONAL CONFERENCE ON OPTICAL MEMS AND NANOPHOTONICS (OMN), IEEE, 17. August 2014 (2014-08-17), Seiten 99-100, XP032658433, ISSN: 2160-5033, DOI: 10.1109/OMN.2014.6924612 ISBN: 978-1-4577-1511-2 [gefunden am 2014-10-14]
- UTKU BARAN ET AL: "Resonant PZT MEMS Scanner for High-Resolution Displays", JOURNAL OF MICROELECTROMECHANICAL SYSTEMS, IEEE SERVICE CENTER, US, Bd. 21, Nr. 6, 1. Dezember 2012 (2012-12-01), Seiten 1303-1310, XP011482665, ISSN: 1057-7157, DOI: 10.1109/JMEMS.2012.2209405
- CHI ZHANG ET AL: "Two-Dimensional Micro Scanner Integrated with a Piezoelectric Actuator and Piezoresistors", SENSORS, MDPI AG, CH, vol. 9, no. 1, 23 January 2009 (2009-01-23), pages 631-644, XP002620220, ISSN: 1424-8220, DOI: 10.3390/S90100631

## Beschreibung

Ausführungsbeispiele der vorliegenden Erfindung beziehen sich auf eine Vorrichtung und ein Verfahren zum resonant Anregen eines Mikrospielgels und zum Bereitstellen eines von einer Auslenkung des Mikrospiegels abhängigen Sensorsignals. Weitere Ausführungsbeispiele beziehen sich auf ein Verfahren zum Herstellen einer solchen Vorrichtung.

Ausführungsbeispiele beziehen sich auf einen piezoelektrischen Positionssensor für piezoelektrisch angetriebene resonante Mikrospiegel.

Möglichkeiten eine Position resonant angetriebener bzw. bewegter MEMS Bauteile (MEMS = Micro electro mechanical system, dt.: mikroelektromechanisches System, kurz Mikrosystem) zu detektieren, wie z.B. von resonant angetriebenen Mikrospiegel, sind begrenzt. Grundsätzlich kann dabei entweder die Bewegung eines Aktuators, der den Mikrospiegel antreibt, oder die Bewegung von dem Mikrospiegel direkt detektiert werden. Die gängigsten Sensorprinzipien für eine Positionsmessung eines Mikrospiegels basieren auf piezoresistiven oder metallischen Dehnungsmessstreifen oder auf kapazitiven oder optischen Verfahren.

Piezoresistive Dehnungsmesstreifen, metallische Dehnungsmessstreifen und kapazitive Messprinzipien erfassen oftmals nur die Aktuatorposition und nicht die eigentliche Position des Mikrospiegels, während optische Verfahren die echte Position von dem Spiegel messen. Die vorgenannten Messmethoden haben jedoch ihre spezifischen Einschränkungen, wie im Folgenden ausgeführt wird.

Die Integration piezoresitiver Sensoren verlangt spezifische Herstellungsmaterialien, wie z.B. dotiertes Polysilizium, damit eine Widerstandsänderung von der mechanischen Spannung im Bauteil erzeugt wird. Dies führt zu einer limitierten Realisierbarkeit [C. Zhang, G. Zhang, and Z. You, "A two-dimensional micro scanner integrated with a piezoelectric actuator and piezoresistors," Sensors, vol. 9, no. 1, pp. 631-644, 2009]. Darüber hinaus sind Piezoresistoren aus einem Halbleitermaterial auch gegenüber Lichteinfall und Änderungen der Temperatur empfindlich, was den Einsatz dieser Klasse von Sensoren in einem Mikrobauelement sehr einschränkt.

Metallische Dehnungsmessstreifen machen es sich zu Nutze, dass viele Metalle über ein piezoresistives Verhalten verfügen, so dass sich deren elektrischer Widerstand bei einer Deformation ändert. Metallische Dehnungsmessstrukturen sind deutlich einfacher zu realisieren als Piezoresistoren aus einem halbleitenden Material, haben aber auch deutlich schlechtere Empfindlichkeiten. Daher erfordert deren Einsatz eine hinreichend große Dehnung entweder der Aktuatoren oder der Federnstrukturen zwischen Aktuator und Mikrospiegel [M. Cueff, E. Defay, G. Le Rhun, P. Rey, F. Perruchot, A. Suhm, and M. Aïd, "Integrated metallic gauge in a piezoelectric cantilever," Sens. Actuators Phys., vol. 172, no. 1, pp. 148-153, Dezember 2011].

Letztlich ist die Größe der Widerstandsänderung maßgeblich vom Design des MEMS Bauelements abhängig. In vielen MEMS Designs fehlen jedoch geeignete Strukturen, die einerseits große Deformationen aufweisen und anderseits hinreichend Platz für einen Dehnungsmessstreifen bereitstellen [U. Baran, D. Brown, S. Holmstrom, D. Balma, W. O. Davis, P. Muralt, and H. Urey, "Resonant PZT MEMS Scanner for High-Resolution Displays," J. Microelectromechanical Syst., vol. 21, no. 6, pp. 1303-1310, Dezember 2012]. Bei solchen MEMS Bauteilen ist daher die Verwendung von Dehnungsmessstreifen mit einer schlechten Empfindlichkeit und einer schlechten Auflösung verbunden.

Elektrostatische Antriebe nutzen sich gegenseitig anziehende Flächen unterschiedlicher Spannungsniveaus als Aktuatoren. Dabei können auch umgekehrt diese Elektrodenflächen als Bestandteil kapazitiver Sensoren genutzt werden, deren Sensorsignal wiederum Aufschluss über die Abstände der Elektroden liefert, was letztlich eine Aussage über die Position des Mikrospiegels liefert [H. G. Xu, T. Ono, and M. Esashi, "Precise motion control of a nanopositioning PZT microstage using integrated capacitive displacement sensors," J. Micromechanics Microengineering, vol. 16, no. 12, p. 2747, Dec. 2006], [T. von Wantoch, C. Mallas, U. Hofmann, J. Janes, B. Wagner, and W. Benecke, "Analysis of capacitive sensing for 2D-MEMS scanner laser projection," in Proc. SPIE 8977, MOEMS and Miniaturized Systems XIII, 2014, p. 897707]. Dabei kann entweder die Position der Aktuatoren als auch die Lage der Mikrospiegel direkt erfasst werden. Nachteilig hierbei sind allerdings die vergleichsweise geringen Signalstärken und die Beeinträchtigung der Signale durch Übersprechen. Nicht zuletzt wird durch die vergleichsweise großen Elektrodenflächen und deren geringen Abständen eine deutlich vergrößerte aerodynamische Reibung des schnell bewegten Mikrospiegels verursacht - was mit einer erheblichen Einbuße in der maximalen Auslenkung des resonanten Mikrospiegels einhergeht.

Optische Messungen stellen eine Möglichkeit dar, die Bewegung der Spiegelplatte direkt zu detektieren. Dabei ist allerdings eine externe Lichtquelle, eine Strahlaufbereitung und ein Detektor (Laserdiode) erforderlich, welche die Kompaktheit eines Bauelements beeinträchtigen [S. Richter, M. Stutz, A. Gratzke, Y. Schleitzer, G. Krampert, F. Hoeller, U. Wolf, L. Riedel, and D. Doering, "Position sensing and tracking with quasistatic MEMS mirrors," 2013, p. 86160D], was letztlich zu komplexen und teureren Konstruktionen führt. Ferner sind Mikrospiegel sowie Verfahren zur Herstellung derselben bekannt [S. Gu-Stoppel, J. Janes, H. J. Quenzer, U. Hofmann and W. Benecke, "Two-dimensional scanning using two single-axis low voltage PZT resonant micromirrors", Proc. SPIE 8977, MOEMS and Miniaturized Systems XIII, 897706 (7 March 2014)].

Der vorliegenden Erfindung liegt somit die Aufgabe zugrunde, ein Konzept zu schaffen, welches die oben genannten Nachteile vermindert oder sogar vermeidet.

Eine Vorrichtung gemäß der Erfindung ist in Anspruch 1 definiert sowie ein Verfahren zur Herstellung der Vorrichtung gemäß Anspruch 1 in Anspruch 11, ein Verfahren zum Betreiben der Vorrichtung nach Anspruch 1 in Anspruch 12 und ein Computerprogramm zur Durchführung des Verfahrens nach Anspruch 12 in Anspruch 13.
- Fig. 1: eine schematische Querschnittsansicht einer Vorrichtung zum resonant Anregen eines Mikrospiegels und Bereitstellen eines von einer Auslenkung des Mikrospiegels abhängigen Sensorsignals, gemäß einem Ausführungsbeispiel der vorliegenden Erfindung;
- Fig. 2: eine schematische Ansicht einer Vorrichtung zum resonant Anregen eines Mikrospiegels und Bereitstellen eines von einer Auslenkung des Mikrospiegels abhängigen Sensorsignals, wobei die Vorrichtung zwei piezoelektrische Aktuatoren aufweist, und wobei einer der zwei piezoelektrischen Aktuatoren als piezoelektrischer Sensor verwendet wird;
- Fig. 3: eine schematische Draufsicht einer Vorrichtung gemäß der Erfindung zum resonant Anregen eines Mikrospiegels und Bereitstellen eines von einer Auslenkung des Mikrospiegels abhängigen Sensorsignals, wobei die Vorrichtung zwei piezoelektrische Aktuatoren und zumindest einen piezoelektrischen Sensor aufweist, gemäß einem Ausführungsbeispiel der vorliegenden Erfindung;
- Fig. 4: ein Flussdiagramm eines Verfahrens zur Herstellung der in Fig. 1 gezeigten Vorrichtung, gemäß einem Ausführungsbeispiel der vorliegenden Erfindung;
- Fig. 5a-d: Querschnitte der Vorrichtung zum resonant Anregen eines Mikrospiegels und Bereitstellen eines von einer Auslenkung des Mikrospiegels abhängigen Sensorsignals nach unterschiedlichen Schritten des in Fig. 4 gezeigten Herstellungsverfahrens; und
- Fig. 6: ein Flussdiagramm eines Verfahrens zum resonanen Anregen eines Mikrospiegels und Bereitstellen eines von einer Auslenkung des Mikrospiegels abhängigen Sensorsignals, gemäß einem Ausführungsbeispiel der vorliegenden Erfindung.
In der nachfolgenden Beschreibung der Ausführungsbeispiele der Erfindung werden in den Figuren gleiche oder gleichwirkende Elemente mit den gleichen Bezugszeichen versehen, so dass deren Beschreibung in den unterschiedlichen Ausführungsbeispielen untereinander austauschbar ist.

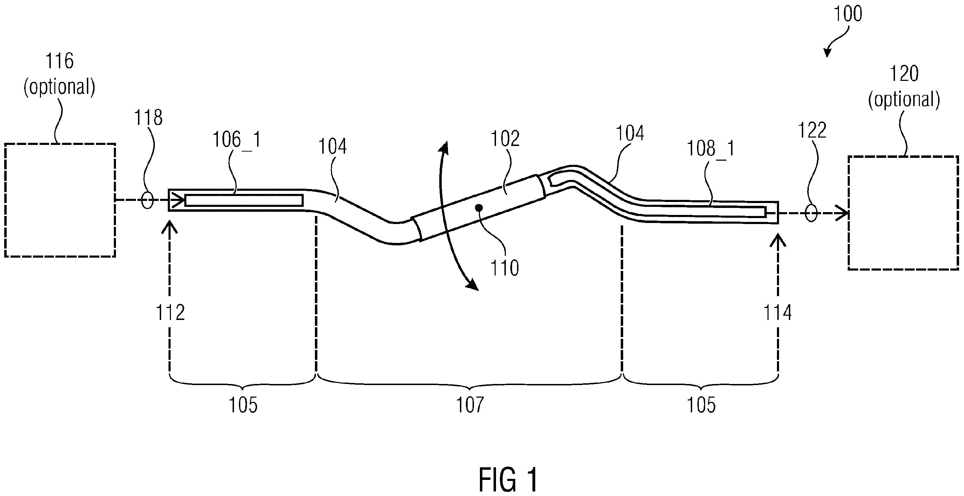

Fig. 1 zeigt eine Vorrichtung 100 zum resonant Anregen eines Mikrospiegels 102 und Bereitstellen eines von einer Auslenkung des Mikrospiegels 102 abhängigen Sensorsignals 122. Die Vorrichtung 100 weist eine Anregungsstruktur 104 auf, die den Mikrospiegel 102 enthält bzw. trägt und zumindest einen piezoelektrischen Aktuator 106_1 bis 106_n (n = 1) aufweist, wobei die Anregungsstruktur 104 ausgebildet ist, um den Mikrospiegel 102 resonant anzuregen, um eine Auslenkung (oder Oszillation bzw. Schwingung) des Mikrospiegels 102 hervorzurufen. Die Vorrichtung 100 weist ferner zumindest einen piezoelektrischen Sensor 108_1 bis 108_m (m = 1) zum Bereitstellen des Sensorsignals 122 auf, wobei der zumindest eine piezoelektrische Sensor 108_1 bis 108_m (m = 1) mit der Anregungsstruktur 104 verbunden ist, so dass bei der resonanten Anregung des Mikrospiegels 102 das Sensorsignal und die Auslenkung (oder Oszillation bzw. Schwingung) des Mikrospiegels 102 eine feste Phasenbeziehung zueinander aufweisen.

Bei Ausführungsbeispielen kann der zumindest eine piezoelektrische Sensor 108_1 bis 108_m (m = 1) mit der Anregungsstruktur 102 derart verbunden sein, dass sich der zumindest eine piezoelektrische Sensor 108_1 bis 108_m mit der Anregungsstruktur 104 mitbewegt. Mit anderen Worten, der zumindest eine piezoelektrische Sensor 108_1 bis 108_m (m = 1) kann derart mit der Anregungsstruktur 104 verbunden sein, dass der zumindest eine piezoelektrische Sensor 108_1 bis 108_m (m = 1) die durch den zumindest einen piezoelektrischen Aktuator 106_1 bis 106_n (n = 1) hervorgerufene Bewegung bzw. Verformung bzw. Krümmung der Anregungsstruktur 104 mitmacht.

Die in Fig. 1 gezeigte Vorrichtung 100 weist beispielhaft einen piezoelektrischen Aktuator 106_1 bis 106_n (n = 1) und einen piezoelektrischen Sensor 108_1 bis 108_m (m = 1) auf. Die Erfindung ist jedoch nicht auf solche Ausführungsbeispiele beschränkt. Bei Ausführungsbeispielen kann die Vorrichtung 100 bis zu n piezoelektrische Aktuatoren 106_1 bis 106_n aufweisen, wobei n eine natürliche Zahl größer gleich eins ist, n ≥ 1. Ferner kann die Vorrichtung 100 bis zu m piezoelektrische Sensoren 108_1 bis 108_m aufweisen, wobei m eine natürliche Zahl größer gleich eins ist, m ≥ 1.

Wie in Fig. 1 zu erkennen ist, kann der Mikrospiegel 102 um eine Torsionsachse (bzw. Auslenkungsachse) 110 herum ausgelenkt werden bzw. um die Torsionsachse 110 herum oszillieren. Die Anregungsstruktur 104 kann dabei achsensymmetrisch zu der Torsionsachse 110 des Mikrospiegels 102 sein.

Wie bereits erwähnt kann die Anregungsstruktur 104 ausgebildet sein, um den Mikrospiegel 102 resonant anzuregen. Beispielsweise kann die Anregungsstruktur 104 hierzu als Resonator ausgebildet sein. Ferner kann die Anregungsstruktur 104 ausgebildet sein, um bei der resonanten Anregung des Mikrospiegels 102 eine feste mechanische Modenform auszubilden, wie z.B. die zweite longitudinale Modenform, d.h. mit der Form einer vollständigen bzw. kompletten Sinusschwingung.

Die Enden 112 und 114 der Anregungsstruktur 104 können beispielsweise in einer Einspannung, z.B. einem Rahmen, z.B. einem Siliziumrahmen, fest eingespannt sein.

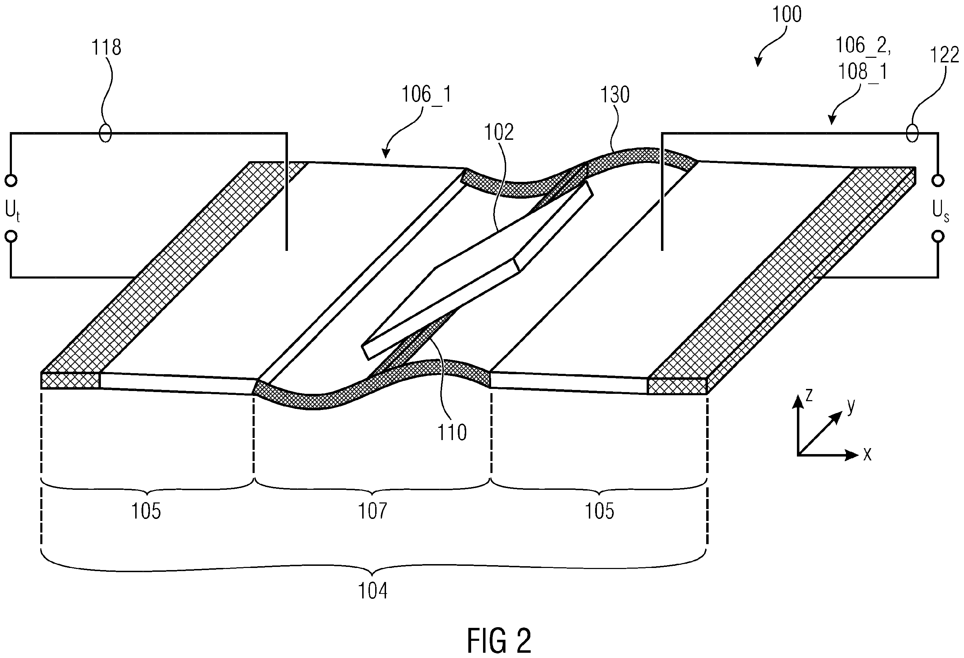

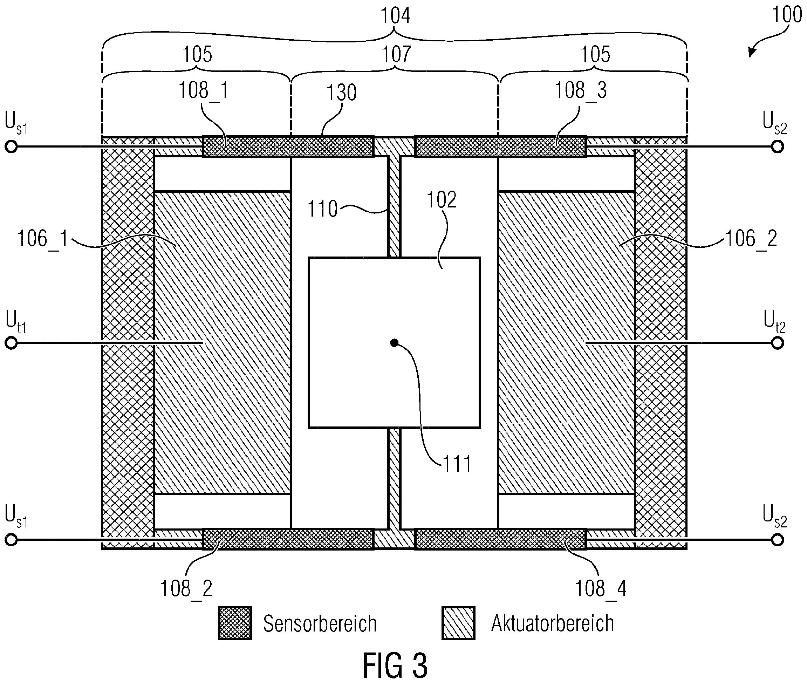

Ferner kann die Anregungsstruktur 104 Bereiche unterschiedlicher Elastizität bzw. Bereiche unterschiedlicher Elastizitätsmodule 105 und 107 aufweisen. Der zumindest eine piezoelektrische Aktuator 106_1 bis 106_n (n = 2) kann dabei in einem ersten Elastizitätsbereich 105 der Anregungsstruktur angeordnet sein, während die Anregungsstruktur 104 den Mikrospiegel 102 in einem zweiten Elastizitätsbereich 107 trägt, wobei der zweite Elastizitätsbereich 107 eine höhere Elastizität aufweist als der erste Elastizitätsbereich 105. Der zumindest eine piezoelektrische Sensor 108_1 bis 108_m (m = 1) kann dabei zumindest teilweise in dem zweiten Elastizitätsbereich 107 der Anregungsstruktur 104 angeordnet sein. Der zweite Elastizitätsbereich 107, d.h. der Bereich höherer Elastizität der Anregungsstruktur 104, kann beispielsweise durch eine Federstruktur (siehe z.B. Fig. 2 und 3) gebildet sein.

Bei Ausführungsbeispielen kann die Vorrichtung 100 ferner eine Steuereinrichtung 116 aufweisen, die ausgebildet sein kann, um ein Steuersignal 118 zum Ansteuern des zumindest einen piezoelektrischen Aktuators 106_1 bis 106_n (n = 1) bereitzustellen, so dass die Anregungsstruktur 104 eine feste mechanische Modenform, wie z.B. die zweite longitudinale Modenform, ausbildet.

Ferner kann die Vorrichtung 100 eine Auswerteeinrichtung 120 aufweisen, die ausgebildet sein kann, um das Sensorsignal 122 auszuwerten und um basierend auf der festen Phasenbeziehung zwischen der Auslenkung (bzw. Oszillation) des Mikrospiegels 102 und dem Sensorsignal 122 die momentane Auslenkung des Mikrospiegels 102 zu ermitteln. Die Auswerteeinrichtung 120 kann ferner ausgebildet sein, um das Sensorsignal 122 auszuwerten und um basierend auf einer Amplitude des Sensorsignals 122 eine Amplitude der Auslenkung des Mikrospiegels 102 zu ermitteln.

Fig. 2 zeigt eine schematische Ansicht der Vorrichtung 100 zum resonant Anregen eines Mikrospiegels 102 und Bereitstellen eines von einer Auslenkung des Mikrospiegels 102 abhängigen Sensorsignals 122, die nicht unter den Ansprüchen fällt.

Die Anregungsstruktur 104 kann eine Federstruktur 130 aufweisen, die den Mikrospiegel 102 trägt und mit dem zumindest einen piezoelektrischen Aktuator 106_1 bis 106_n (n = 2) verbunden ist.

Bei Ausführungsbeispielen kann die Anregungsstruktur 104 zwei piezoelektrische Aktuatoren 106_1 und 106_n (n = 2) aufweisen, wobei die Federstruktur 130 (symmetrisch) zwischen den zwei piezoelektrischen Aktuatoren 106_1 und 106_n (n = 2) angeordnet sein kann, wie dies in Fig. 2 zu erkennen ist.

Die zwei piezoelektrische Aktuatoren 106_1 bis 106_n (n = 2) sind dabei in einem ersten Elastizitätsbereich 105 der Anregungsstruktur 104 angeordnet, während die Federstruktur 130 einen zweiten Elastizitätsbereich 107 der Anregungsstruktur 104 bildet, wobei der zweite Elastizitätsbereich 107 eine höhere Elastizität aufweist als der erste Elastizitätsbereich 105.

Wie in Fig. 2 ferner zu erkennen ist, kann einer der zwei piezoelektrischen Aktuatoren 106_1 bis 106_n (n = 2) als der zumindest eine piezoelektrischer Sensor 108_1 bis 108_m (m = 1) verwendet werden.

Mit anderen Worten, ein erster piezoelektrischer Aktuator 106_1 der zwei piezoelektrischen Aktuatoren 106_1 und 106_n (n = 2) kann ausgebildet sein, um den Mikrospiegel 102 resonant anzuregen, um eine Auslenkung des Mikrospiegels 102 hervorzurufen. Hierzu kann an dem ersten piezoelektrischen Aktuator 106_1 beispielsweise ein Steuersignal 118, wie z.B. eine Steuerspannung Uₜ, derart angelegt werden, dass der erste piezoelektrische Aktuator 106_1 den Mikrospiegel 102 resonant anregt, um eine Auslenkung des Mikrospiegels 102 hervorzurufen. An dem zweiten piezoelektrischen Aktuator 106_2 wird in diesem Fall kein Steuersignal angelegt, sondern ein Sensorsignal 122, wie z.B. eine Sensorspannung Uₛ, abgegriffen, die z.B. von der Auswerteeinrichtung 120 ausgewertet werden kann, um basierend auf der festen Phasenbeziehung (bzw. Phasenlage oder Phasenverschiebung) zwischen dem Sensorsignal 122, z.B. der Sensorspannung Uₛ, und der Auslenkung des Mikrospiegels 102 die momentane Auslenkung des Mikrospiegels 102 zu ermitteln.

Mit anderen Worten, Fig. 2 zeigt eine schematische Darstellung der Umsetzung des direkten piezoelektrischen Messverfahrens für 1D resonante Mikrospiegel 102 (Uₜ: Treiberspannung, Uₛ: Sensorsignal).

Der direkte piezoelektrische Effekt ist die Eigenschaft von piezoelektrischen Materialien, mechanische Energie in elektrische Energie umzuwandeln. Dies stellt eine Möglichkeit dar, die Bewegung der Mikrospiegel 102 durch piezoelektrische Sensoren 108_1 bis 108_m zu erfassen.

Der indirekte Piezoelektrische Effekt wird für den Antrieb der 1D resonanten Mikrospiegel eingesetzt (siehe Fig. 2). Während die Antriebsspannung Uₜ an einem der piezoelektrische Aktuatoren 106_1 angelegt wird, wird die durch den direkten piezoelektrischen Effekt generierte Spannung Uₛ von dem anderen als Sensor 108_1 verwendeten Aktuator 106_2 bereitgestellt und z.B. von der Auswerteinrichtung 120 erfasst bzw. gemessen.

Der Antrieb des Spiegels 102 erfolgt dabei entweder über eine periodische Anregung einer der beiden Aktuatoren 106_1 oder aber durch beide Aktuatoren 106_1 und 106_2 wobei deren Anregung dann um 180° Phasenversetzt zu einander erfolgt. Beide Aktuatoren 106_1 und 106_n (n = 2) sind identisch und sind symmetrisch um die Torsionsachse 110 des Spiegels 102 angeordnet, mit dem diese durch geeignete Federstrukturen 130 verbunden sind. Die Aktuatoren 106_1 bis 106_n (n = 2) können dabei zusätzlich mit piezoelektrischen Sensorstrukturen 108_1 bis 108_m versehen werden (vgl. Fig. 3) oder aber selbst als Sensor eingesetzt werden. Ein etwaiges elektrisches Übersprechen zwischen Sensor und Aktuator kann durch eine vollständige galvanische Trennung (auch keine gemeinsame Masse-elektrode) erreicht werden.

Im einfachsten Fall kann der Spiegel 102 einseitig angeregt werden und der gegenüberliegende Aktuator 106_2 fungiert dann als ein reines piezoelektrisches Sensorelement.

In diesem Fall wird vom ersten Aktuator 106_1 zunächst die Spiegelplatte 102 über die dazwischenliegenden Federstrukturen 130 periodisch angeregt und ausgelenkt, woraufhin anschließend die Spiegeltorsion eine gegenphasige Bewegungen auf den zweiten Aktuator 106_2 überträgt. Dadurch spiegelt die im zweiten Aktuator 106_2 induzierte piezoelektrische Spannung die mechanische Auslenkung des Spiegels 102 wieder.

Bei spezifischen Resonanzfrequenzen wird eine besonders große Amplitude der Spiegelauslenkung erreicht. Durch die mechanische Kopplung zwischen Aktuator, Spiegelplatte und Sensor weisen die periodischen Signale bzw. Auslenkungen nicht nur die gleichen Frequenzen auf, vielmehr sind die Amplituden der Signale des Sensors und die Winkelverstellung des Spiegels 102 direkt zu einander proportional.

Feste Frequenzen und eine Proportionalität der Sensorkennlinie sind jedoch alleine nicht ausreichend, ebenfalls müssen die relativen Beziehungen der Phasen zwischen dem periodischen Sensorsignal 122 und der periodischen Verkippung des Spiegels 102 bekannt sein um die genaue Lage des Spiegels 102 zu ermitteln.

Kritisch könnten hierbei insbesondere das Auftreten von Phasenverschiebungen zwischen den verschiedenen Komponenten des Systems sein, wie es z.B. bei einem harmonischen mechanischen Oszillator unter Anregung einer externen Kraft auftritt, wenn die Anregungsfrequenz über die eigentliche Resonanzfrequenz hinweg verschoben wird. Dabei ergeben sich Verschiebung um 180°, die zudem auch noch in derer Nähe der Resonanz (abhängig von der Dämpfung) innerhalb einer geringen Frequenzänderung auftreten können. Da bei MEMS Resonatoren und insbesondere Mikrospiegeln immer auch thermische Effekte auftreten, die letztlich zu einem Drift (dt. Verschiebung) in der Resonanzfrequenz führen und zudem vergleichsweise geringe Dämpfungsverluste in den mikrotechnisch herstellten Resonatoren auftreten, können sehr schnell sehr große Phasenverschiebung zwischen dem Anregungssignal und der aktuellen Position des Oszillators auftreten.

Im Unterschied zum klassischen Oszillator der extern angetrieben wird, ist hier das Sensorelement integraler Bestandteil des Resonators, der eine feste mechanische Modenformen im Resonanz ausbildet (stehende Welle). Innerhalb einer jeden Mode bleiben die relativen Phasenlagen zwischen den einzelnen Elementen des Resonators konstant auch wenn die Anregungsfrequenz relativ zur Resonanzfrequenz variiert. Je nach angeregter Mode können sich jedoch die Phasenlagen zwischen den einzelnen Elementen jedoch ändern und sind ein Charakteristikum der jeweiligen Moden.

Für den Betrieb des Mikrospiegels 102 ist die zweite Mode bzw. zweite longitudinale Mode allerdings besonders vorteilhaft, die wie eine Sinuswelle im Bereich der Torsion des Spiegels eine möglichst große Torsion erzeugt.

Fig. 3 zeigt eine schematische Draufsicht einer Vorrichtung 100 gemäß der Erfindung zum resonant Anregen eines Mikrospiegels 102 und Bereitstellen eines von einer Auslenkung des Mikrospiegels 102 abhängigen Sensorsignals 122. Wie in Fig. 3 zu erkennen ist, weist die Anregungsstruktur 104 eine Federstruktur 130 und zwei piezoelektrische Aktuatoren 106_1 und 106_n (n = 2) auf, wobei die Federstruktur 130 (symmetrisch) zwischen den zwei piezoelektrischen Aktuatoren 106_1 und 106_n (n = 1) angeordnet ist.

Ferner weist die in Fig. 3 gezeigte Vorrichtung 100 vier piezoelektrische Sensoren 108_1 bis 108_m (m = 4) auf. Die vier piezoelektrische Sensoren 108_1 bis 108_m (m = 4) sind symmetrisch zu der Torsionsachse 110 des Mikrospiegels 102, im Detail symmetrisch zu einem Schwerpunkt 111 des Mikrospiegels 102 bzw. einem Mittelpunkt 111 der Torsionsachse 110 des Mikrospiegels 102 angeordnet. Ferner sind die vier piezoelektrische Sensoren 108_1 bis 108_m (m = 4) jeweils mit der Federstruktur 130 verbunden, um sich mit der Federstruktur 130 mitzubewegen. Des Weiteren erstrecken sich die vier piezoelektrische Sensoren 108_1 bis 108_m (m = 4) jeweils zumindest teilweise über die Federstruktur 130, im Detail jeweils über den ersten Elastizitätsbereich 105 und den zweiten Elastizitätsberiech 107 der Anregungsstruktur 104.

Die in Fig. 3 gezeigte Vorrichtung 100 mit den zwei piezoelektrischen Aktuatoren 106_1 und 106_n (n = 2) und den vier piezoelektrischen Sensoren 108_1 und 108_m (m = 4) kann beispielsweise erhalten werden, indem ein Halbleitersubstrat bereitgestellt wird, eine piezoelektrische Schicht auf das Halbleitersubstrat abgeschieden wird und die piezoelektrische Schicht und das Halbleitersubstrat anschließend strukturiert werden, so dass die in Fig. 3 gezeigten Bereiche erhalten werden, die die zwei piezoelektrischen Aktuatoren 106_1 und 106_n (n = 2) sowie die vier piezoelektrischen Sensoren 108_1 und 108_m (m = 4) bilden.

Mit anderen Worten, Fig. 3 zeigt eine schematische Darstellung des direkten piezoelektrischen Messverfahrens mit Messstreifen für 1D Mikrospiegel (Uₜ: Treiberspannung, Uₛ: Sensorsignal).

Grundsätzlich können die piezoelektrischen Sensoren 108_1 bis 108_m (m = 4) auch auf den Federn 130 platziert werden (siehe Fig. 3). Während ein großer Anteil der PZT Aktuatoren (PZT = Blei-Zirkonat-Titanat) zum Antrieb dient, liegen dünne PZT Streifen 108_1 bis 108_m (m = 4) über den Verbindungsfedern 130, da auf denen die Areale mit den höchsten Dehnungen bei der Spiegeltorsion vorkommen.

Besonders vorteilhaft erscheinen jedoch Anordnungen der Piezosensoren 108_1 bis 108_m anstelle eines zweiten Aktuators oder parallel zu den beiden Aktuatoren 106_1 bis 106_n (n = 2) zu sein, weil hier homogene (keine ungewollte Kompensation des Sensorsignals) und hinreichend große Krümmungen im Betreib auftreten, was sich in einem entsprechend großen Sensorsignal niederschlägt. Weiterhin müssen keine metallischen Materialien über die Federelemente 130 geführt werden, wodurch sowohl größere Dämpfungsverluste durch die Plastizität der Metalle als auch thermische induzierte Effekte (Bimetall), die sich negativ auf die Stabilität der Resonanzfrequenz auswirken, vermieden werden können. Nicht zuletzt liegen hier Bereiche, wo der Sensor vergleichsweise groß ausgeführt werden kann, was ebenfalls zu einem verbesserten Sensorsignal führt.

Bei Ausführungsbeispielen weist ein komplettes Oszillatorsystem einen Mikrospiegel 102 und zwei außenstehende piezoelektrische Aktuatoren 106_1 und 106_n (n = 2) auf. Auch wenn bei separater Betrachtung die Aktuatoren 106_1 und 106_n (n = 2) und der Mikrospiegel 102 verschiedene Resonanzfrequenzen aufweisen, besteht eine gemeinsame eigene Frequenz und ein konsistentes, resonantes Verhalten bei diesem System 100. Das piezoelektrische Material wird nicht nur für den Antrieb, sondern auch für die Positionserfassung verwendet.

Vorteile hiervon sind, dass keine separaten Materialien oder Herstellungsschritte für die piezoelektrischen Aktuatoren 106_1 bis 106_n und die piezoelektrischen Sensorelemente 108_1 bis 108_m nötig sind, dass eine monolithische Herstellungstechnologie genutzt werden kann, und dass wegen der zuverlässigen Resonanz des kompletten Systems 100 ein konstantes Bewegungsverhältnis zwischen den piezoelektrischen Sensoren 108_1 bis 108_m und dem Mikrospiegel 102 besteht, womit zwar die Aktuatorbewegung erfasst wird, diese aber genau die Bewegung des Mikrospiegels 102 widerspiegelt.

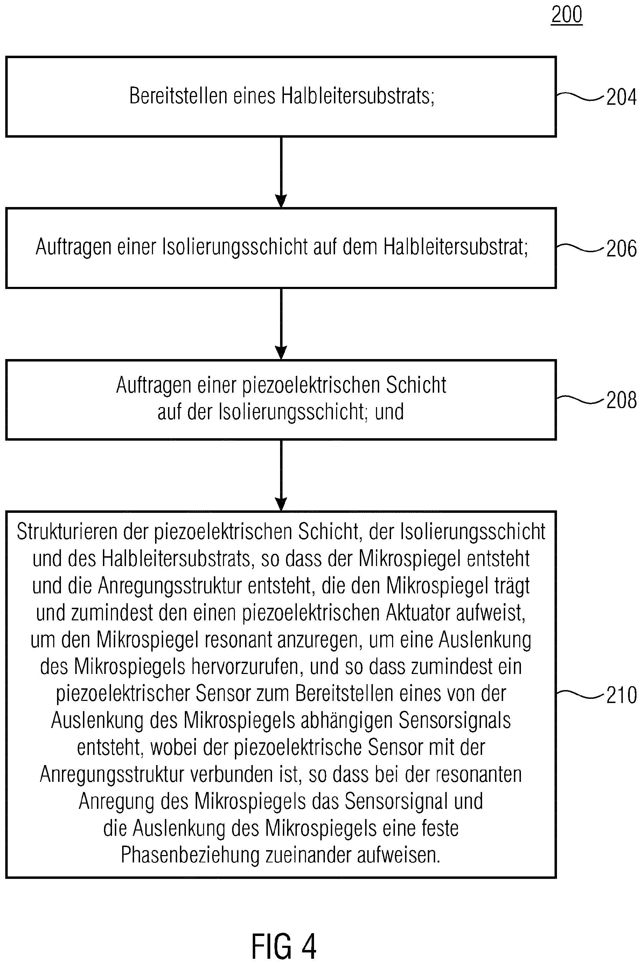

Fig. 4 zeigt ein Flussdiagramm eines Verfahrens 200 zum Herstellen der in Fig. 1 gezeigten Vorrichtung 100. Das Verfahren umfasst einen Schritt 204 des Bereitstellens eines Halbleitersubstrats; einen Schritt 206 des Auftragens einer Isolierungsschicht auf dem Halbleitersubstrat; einen Schritt 208 des Auftragens einer piezoelektrischen Schicht auf der Isolierungsschicht; und einen Schritt 210 des Strukturierens der piezoelektrischen Schicht, der Isolierungsschicht und des Halbleitersubstrats, so dass der Mikrospiegel 102 entsteht und die Anregungsstruktur 104 entsteht, die der Mikrospiegel 102 trägt und zumindest den einen piezoelektrischen Aktuator 106_1 bis 106_n aufweist, um den Mikrospiegel 102 resonant anzuregen, um eine Auslenkung des Mikrospiegels 102 hervorzurufen, und so dass zumindest ein piezoelektrischer Sensor 108_1 bis 108_m zum Bereitstellen eines von der Auslenkung des Mikrospiegels 102 abhängigen Sensorsignals entsteht, wobei der zumindest eine piezoelektrische Sensor 108_1 bis 108_m mit der Anregungsstruktur 104 verbunden ist, so dass bei der resonanten Anregung des Mikrospiegels 102 das Sensorsignal und die Auslenkung des Mikrospiegels 102 eine feste Phasenbeziehung zueinander aufweisen.

Bei Ausführungsbeispielen kann der Schritt 208 des Auftragens der piezoelektrischen Schicht einen Schritt des Auftragens einer ersten Elektrodenschicht, z.B. aus Aluminium, Platin und/oder Titan, auf die Isolierungsschicht; einen Schritt des Auftragens einer Blei-Zirkonat-Titanat-Schicht auf die erste Elektrodenschicht; und einen Schritt des Auftragens einer zweiten Elektrodenschicht, z.B. aus Chrom oder Gold, auf die Blei-Zirkonat-Titanat-Schicht aufweisen.

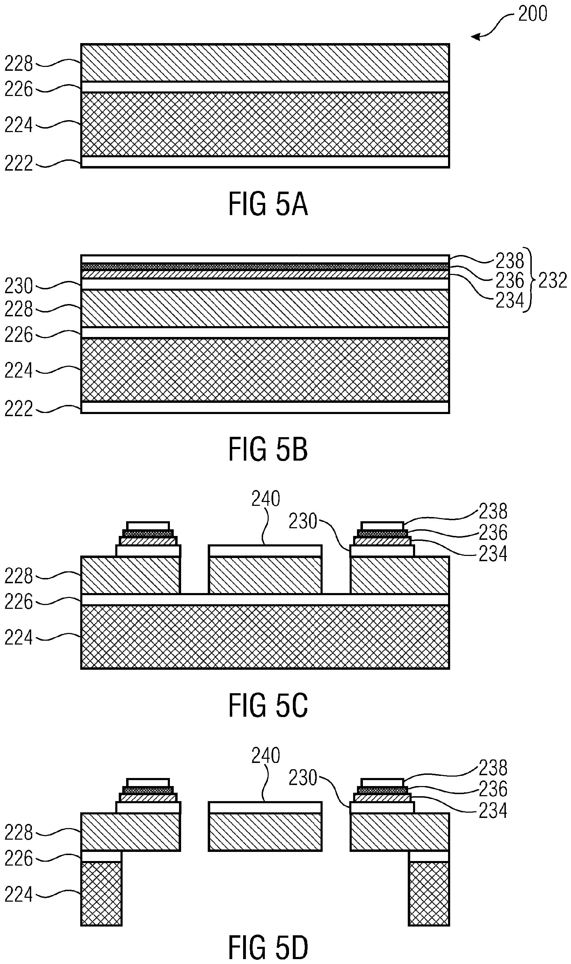

Im Folgenden wird das in Fig. 4 gezeigte Verfahren 200 zum Herstellen der in Fig. 1 gezeigten Vorrichtung 100 anhand der Fig. 5a bis 5d näher erläutert.

Fig. 5a zeigt eine schematische Querschnittsansicht der Vorrichtung nach dem Schritt 204 des Bereitstellens des Halbleitersubstrats 220. Das Halbleitersubstrat 220 kann beispielsweise Silizium aufweisen. Wie in Fig. 5a zu erkennen ist, kann das Halbleitersubstrat 220 bei Ausführungsbeispielen ein SOI Wafer (SOI = Silicon on Insulator, dt. Silizium auf einem Isolator) sein. Das Halbleitersubstrat 220 kann einen Stapel aus einer ersten Siliziumdioxidschicht 222 (z.B. mit einer Dicke von 1 µm), einer Siliziumschicht 224 (z.B. mit einer Dicke von 725 µm), einer zweiten Siliziumdioxidschicht 226 (z.B. mit einer Dicke von 1 µm) und einer Polysiliziumschicht 228 (z.B. mit einer Dicke von 80µ) aufweisen.

Fig. 5b zeigt eine Querschnittsansicht der Vorrichtung 100 nach dem Schritt 206 des Auftragens einer Isolierungsschicht 230 auf dem Halbleitersubstrat 220 und dem Schritt 208 des Auftragens der piezoelektrischen Schicht 232 auf der Isolierungsschicht 230. Die piezoelektrische Schicht 232 kann beispielsweise einen Stapel aus einer ersten Elektrodenschicht (z.B. Titan und/oder Platin) 234, einer Blei-Zirkonat-Titanat-Schicht 236 und einer zweiten Elektrodenschicht (z.B. Chrom und/oder Gold) aufweisen.

Die erste Elektrodenschicht 234 kann beispielsweise durch Aufdampfen auf die zweite zweiten Siliziumdioxidschicht 226 aufgebracht werden. Die Blei-Zirkonat-Titanat-Schicht 236 (z.B. mit einer Dicke von 2 µm) kann beispielsweise auf die erste Elektrodenschicht 234 aufgesputtert werden, z.B. unter Verwendung einer heißen Magnetfeldröhre.

Fig. 5c zeigt eine Querschnittsansicht der Vorrichtung 100 nach dem Schritt 208 des Strukturierens der piezoelektrischen Schicht 232, der Isolierungsschicht 230 und der Polysiliziumschicht 228 des Halbleitersubstrats 220. Dabei kann zunächst die zweite Elektrodenschicht (z.B. Chrom und/oder Gold) 238 durch Nassätzen strukturiert werden, während die Blei-Zirkonat-Titanat-Schicht 236 und die erste Elektrodenschicht (z.B. Titan und/oder Platin) 234 durch Trockenätzen strukturiert werden können. Die Polysiliziumschicht 228 kann beispielsweise durch reaktives lonentiefenätzen strukturiert werden, wobei vor dem reaktiven lonentiefenätzen der Polysiliziumschicht eine optisch reflektierende Schicht, z.B. eine Aluminiumschicht 240, abgeschieden werden kann, um den Mikrospiegel zu erhalten.

Fig. 5d zeigt eine Querschnittsansicht der Vorrichtung 100 nach einem Schritt 208 des Strukturierens der Siliziumschicht 224 und der zweiten Siliziumdioxidschicht 226 des Halbleitersubstrats 220. Die Siliziumschicht 224 und die zweite Siliziumdioxidschicht 226 können beispielsweise durch rückseitiges reaktives lonentiefenätzen strukturiert werden, so dass der Mikrospiegel freigelegt wird.

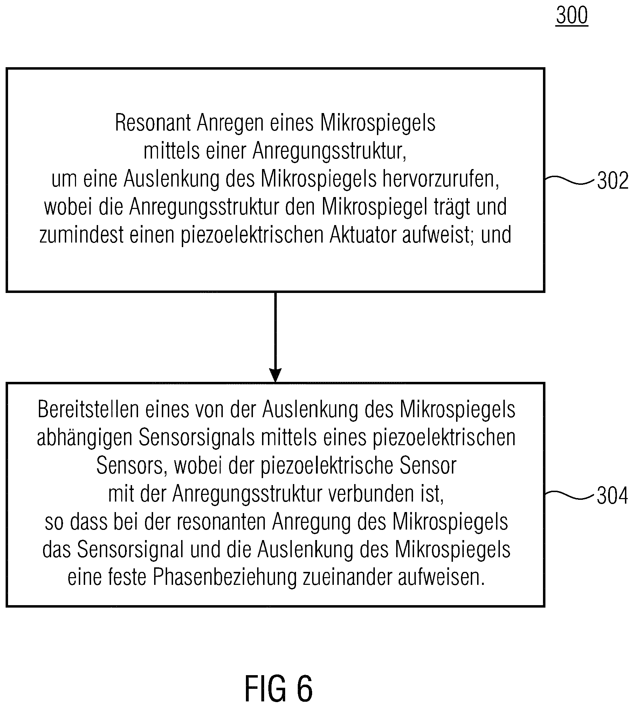

Fig. 6 zeigt ein Verfahren 300 zum resonant Anregen eines Mikrospiegels 102 und Bereitstellen eines von der Auslenkung des Mikrospiegels 102 abhängigen Sensorsignals. Das Verfahren 300 umfasst einen Schritt 302 des resonant Anregens des Mikrospiegels 102 mittels einer Anregungsstruktur 104, um eine Auslenkung des Mikrospiegels 102 hervorzurufen, wobei die Anregungsstruktur 104 den Mikrospiegel 102 trägt und zumindest einen piezoelektrischen Aktuator 106_1 bis 106_n aufweist; und einen Schritt 304 des Bereitstellens eines von der Auslenkung des Mikrospiegels 102 abhängigen Sensorsignals mittels zumindest eines piezoelektrischen Sensors 108_1 bis 108_m, wobei der zumindest eine piezoelektrische Sensor 108_1 bis 108_m mit der Anregungsstruktur verbunden ist, so dass bei der resonanten Anregung des Mikrospiegels 102 das Sensorsignal und die Auslenkung des Mikrospiegels 102 eine feste Phasenbeziehung zueinander aufweisen.

Bei Ausführungsbeispielen kann der Mikrospiegel 102 piezoelektrisch in Resonanz versetzt werden.

Bei Ausführungsbeispielen kann die gesamte Struktur 100 symmetrisch aufgebaut sein, wobei der Mikrospiegel 102 von den Antriebssensorstrukturen umfasst sein kann.

Bei Ausführungsbeispielen kann das gesamte Element mittels Siliziumtechnologie auf Waferebene hergestellt werden, wobei jeweils eine Vielzahl gleicher MEMS Bauelemente erzeugt werden können.

Bei Ausführungsbeispielen können die integrierten Piezoaktuatoren 106_1 bis 106_n dünne Siliziumstrukturen aufweisen, auf die eine dünne piezoelektrische Schicht, in der Regel eine PZT-Schicht (Blei-Zirkonat-Titanat), und dessen Elektroden aufgebaut werden.

Bei Ausführungsbeispielen kann die Vorrichtung 100 zusätzliche integrierte Piezosensoren bzw. piezoelektrische Sensoren zur Erfassung der Winkelstellung aufweisen.

Bei Ausführungsbeispielen können die piezoelektrischen Sensoren 108_1 bis 108_m von den Antriebsstrukturen bzw. Anregungsstrukturen 106_1 bis 106_n galvanisch getrennt sein.

Bei Ausführungsbeispielen kann die gesamte Struktur 100 bestehend aus den Antrieben (piezoelektrischen Aktuatoren) 106_1 bis 106_n, Sensoren 108_1 bis 108_m und Spiegel 102 resonant in einer Mode betrieben werden. Dies sinusförmige Mode (z.B. stehende Welle), die punktsymmetrisch um den Spiegel 102 sein kann, führt zu besonders großen Winkelbewegungen des Spiegels 102.

Bei Ausführungsbeispielen weisen in dieser stehenden Welle die Aktuatorstrukturen 106_1 bis 106_n und Sensorstrukturen 108_1 bis 108_m gegenüber der Position des Spiegels 102 eine feste Phasendifferenz auf, die sich auch bei Frequenzänderungen um diese Eigenresonanz nur sehr geringfügig ändern. Erst bei Anregungsfrequenzen, die in erheblichem Maße von der Resonanz dieser Mode abweichen, treten deutliche Verschiebungen in den relativen Phasenlagen der einzelnen Komponenten auf.

Bei Ausführungsbeispielen ist die Amplitude des Sensorsignals proportional zur Verkippung des Mikrospiegels 102.

Bei Ausführungsbeispielen können die Sensorsignale für die Regelung der Piezoaktuatoren 106_1 bis 106_n der Antriebe verwendet werden, da die relative Phasendifferenz zur Winkelauslenkung des Mikrospiegels 102 und dessen Amplitude bekannt sind.

Bei Ausführungsbeispielen können die piezoelektrischen Sensorstrukturen 108_1 bis 108_m in den gleichen Herstellungsschritten wie die Aktuatoren 106_1 bis 106_n hergestellt werden.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar, wie in Anspruch 11 definiert.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten ein-leuchten werden. Deshalb ist beabsichtigt, dass die Erfindung lediglich durch den Schutz-umfang der nachstehenden Patentansprüche und nicht durch die spezifischen Einzelheiten, die anhand der Beschreibung und der Erläuterung der Ausführungsbeispiele hierin präsentiert wurden, beschränkt sei.

## Patentansprüche

1. Vorrichtung (100), mit folgenden Merkmalen:
einem Mikrospiegel (102);
einer Anregungsstruktur (104), die den Mikrospiegel (102) enthält oder trägt und zumindest einen piezoelektrischen Aktuator (106_1:106_n) aufweist, wobei die Anregungsstruktur (104) ausgebildet ist, um den Mikrospiegel (102) resonant anzuregen, um eine Auslenkung des Mikrospiegels (102) hervorzurufen; und
zumindest einem piezoelektrischen Sensor (108_1:108_m) zum Bereitstellen eines von der Auslenkung des Mikrospiegels (102) abhängigen Sensorsignals (122), wobei der piezoelektrische Sensor (108_1:108_m) mit der Anregungsstruktur (104) mechanisch verbunden ist, so dass bei der resonanten Anregung des Mikrospiegels (102) das Sensorsignal (122) und die Auslenkung des Mikrospiegels (102) eine feste Phasenbeziehung zueinander aufweisen;
wobei die Anregungsstruktur (104) eine Federstruktur (130) aufweist, die den Mikrospiegel (102) trägt;
wobei die Anregungsstruktur (104) zwei piezoelektrische Aktuatoren (106_1, 106_2) aufweist, und wobei die Federstruktur (130) zwischen den zwei piezoelektrischen Aktuatoren (106_1, 106_2) angeordnet ist und mit den zwei piezoelektrischen Aktuatoren (106_1, 106_2) verbunden ist; und
wobei der zumindest eine piezoelektrische Sensor (108_1:108_m) mit der Federstruktur (130) verbunden ist, um sich mit der Federstruktur (130) mitzubewegen; wobei sich der zumindest eine piezoelektrische Sensor (108_1:108_m) zumindest teilweise über die Federstruktur 130 erstreckt;
wobei die Federstruktur (130) H-förmig ist,
wobei der Mikrospiegel (102) von einem Querträger der H-förmigen Federstruktur (130) getragen wird,
wobei der zumindest eine piezoelektrische Sensor (108_1:108_m) mit zumindest einem Längsträger der H-förmigen Federstruktur (130) verbunden ist.

2. Vorrichtung (100) nach einem der vorangehenden Ansprüche, wobei der zumindest eine piezoelektrische Sensor (108_1:108_m) mit der Anregungsstruktur (104) verbunden ist, um sich mit der Anregungsstruktur (104) mitzubewegen.

3. Vorrichtung (100) nach einem der vorangehenden Ansprüche, wobei der piezoelektrische Sensor (108_1:108_m) von dem zumindest einen piezoelektrischen Aktuator (106_1:106_n) vollständig galvanisch getrennt ist.

4. Vorrichtung (100) nach einem der vorangehenden Ansprüche, wobei die Anregungsstruktur (104) achsensymmetrisch zu einer Torsionsachse des Mikrospiegels (102) ist, wobei der Mikrospiegel (102) um die Torsionsachse herum auslenkbar ist.

5. Vorrichtung (100) nach einem der vorangehenden Ansprüche, wobei die Anregungsstruktur (104) als Resonator ausgebildet ist.

6. Vorrichtung (100) nach Anspruch 5, wobei die Anregungsstruktur (104) ausgebildet ist, um bei der resonanten Anregung des Mikrospiegels (102) eine feste mechanische Modenform auszubilden.

7. Vorrichtung (100) nach einem der vorangehenden Ansprüche, wobei eine Amplitude des Sensorsignals (122) proportional zu einer Amplitude der Auslenkung des Mikrospiegels (102) ist.

8. Vorrichtung (100) nach einem der vorangehenden Ansprüche, wobei die Vorrichtung eine Steuereinrichtung (116) aufweist, die ausgebildet ist, um ein Steuersignal (118) zum Ansteuern des zumindest einen piezoelektrischen Aktuators (106_1:106_n) bereitzustellen, so dass die Anregungsstruktur (104) eine feste mechanische Modenform ausbildet.

9. Vorrichtung (100) nach Anspruch 8 wobei die feste mechanische Modenform die zweite longitudinale Mode ist.

10. Vorrichtung (100) nach einem der vorangehenden Ansprüche, wobei die Vorrichtung eine Auswerteeinrichtung (120) aufweist, die ausgebildet ist, um das Sensorsignal (122) auszuwerten und um basierend auf der festen Phasenbeziehung die momentane Auslenkung des Mikrospiegels (102) zu ermitteln.

11. Verfahren (200) zum Herstellen einer Vorrichtung gemäß Anspruch 1, wobei das Verfahren folgende Schritte umfasst:
Bereitstellen (204) eines Halbleitersubstrats;
Auftragen (206) einer Isolierungsschicht auf dem Halbleitersubstrat;
Auftragen (208) einer piezoelektrischen Schicht auf der Isolierungsschicht; und
Strukturieren (210) der piezoelektrischen Schicht, der Isolierungsschicht und des Halbleitersubstrats, so dass der Mikrospiegel (102) entsteht und die Anregungsstruktur (104) entsteht, die den Mikrospiegel (102) trägt und zumindest den einen piezoelektrischen Aktuator (106_1:106_n) aufweist, um den Mikrospiegel (102) resonant anzuregen, um eine Auslenkung des Mikrospiegels (102) hervorzurufen,
wobei die Anregungsstruktur (104) eine Federstruktur (130) aufweist, die den Mikrospiegel (102) trägt, wobei die Anregungsstruktur (104) zwei piezoelektrische Aktuatoren (106_1, 106_2) aufweist, und wobei die Federstruktur (130) zwischen den zwei piezoelektrischen Aktuatoren (106_1, 106_2) angeordnet ist und mit den zwei piezoelektrischen Aktuatoren (106_1, 106_2) verbunden ist; und so dass zumindest ein piezoelektrischer Sensor (108_1:108_m) zum Bereitstellen eines von der Auslenkung des Mikrospiegels (102) abhängigen Sensorsignals (122) entsteht,
wobei der piezoelektrische Sensor (108_1:108_m) mit der Anregungsstruktur (104) verbunden ist, so dass bei der resonanten Anregung des Mikrospiegels (102) das Sensorsignal (122) und die Auslenkung des Mikrospiegels (102) eine feste Phasenbeziehung zueinander aufweisen, wobei der zumindest eine piezoelektrische Sensor (108_1:108_m) mit der Federstruktur (130) verbunden ist, um sich mit der Federstruktur (130) mitzubewegen, wobei sich der zumindest eine piezoelektrische Sensor (108_1:108_m) zumindest teilweise über die Federstruktur 130 erstreckt;
wobei die Federstruktur (130) H-förmig ist,
wobei der Mikrospiegel (102) von einem Querträger der H-förmigen Federstruktur (130) getragen wird,
wobei der zumindest eine piezoelektrische Sensor (108_1:108_m) mit zumindest einem Längsträger der H-förmigen Federstruktur (130) verbunden ist.

12. Verfahren (300) zum Betreiben der Vorrichtung (100) nach Anspruch 1, wobei das Verfahren (300) folgenden Schritte aufweist:
resonant Anregen (302) des Mikrospiegels (102) mittels der Anregungsstruktur (104), um eine Auslenkung des Mikrospiegels(102) hervorzurufen; und
Bereitstellen (304) eines von der Auslenkung des Mikrospiegels (102) abhängigen Sensorsignals (122) mittels des piezoelektrischen Sensors (108_1:108_m).

13. Computerprogramm zur Durchführung des Verfahrens nach Anspruch 12 in einer Vorrichtung nach Anspruch 1, wenn das Computerprogramm auf einem Computer oder Mikroprozessor ausgeführt wird.

## Claims

1. An apparatus (100) comprising:
a micromirror (102);
an excitation structure (104) containing or supporting the micromirror (102) and comprising at least one piezoelectric actuator (106_1:106 _n), the excitation structure (104) being configured to resonantly excite the micromirror (102) so as to cause a deflection of the micromirror (102); and
at least one piezoelectric sensor (108_1:108_m) for providing a sensor signal (122) dependent on the deflection of the micromirror (102), the piezoelectric sensor (108_1:108_m) being mechanically connected to the excitation structure (104) so that, during the resonant excitation of the micromirror (102), the sensor signal (122) and the deflection of the micromirror (102) exhibit a fixed mutual phase relationship;
the excitation structure (104) comprising a spring structure (130) supporting the micromirror (102);
the excitation structure (104) comprising two piezoelectric actuators (106_1, 106_2), and the spring structure (130) being arranged between the two piezoelectric actuators (106_1, 106_2) and being connected to the at least two piezoelectric actuators (106_1:106_n); and
the at least one piezoelectric sensor (108_1:108_m) being connected to the spring structure (130) so as to move along with the spring structure (130);
the at least one piezoelectric sensor (108_1:108_m) extending at least partially across the spring structure 130;
the spring structure (130) being H-shaped,
the micromirror (102) being supported by a crossbar of the H-shaped spring structure (130),
the at least one piezoelectric sensor (108_1:108_m) being connected to at least one longitudinal bar of the H-shaped spring structure (130).

2. The apparatus (100) as claimed in any of the previous claims, wherein the at least one piezoelectric sensor (108_1:108_m) is connected to the excitation structure (104) so as to move along with the excitation structure (104).

3. The apparatus (100) as claimed in any of the previous claims, wherein the piezoelectric sensor (108_1:108_m) is completely galvanically separate from the at least one piezoelectric actuator (106_1:106_n).

4. The apparatus (100) as claimed in any of the previous claims, wherein the excitation structure (104) is axially symmetrical to a torsion axis of the micromirror (102), the micromirror (102) being deflectable about the torsion axis.

5. The apparatus (100) as claimed in any of the previous claims, wherein the excitation structure (104) is configured as a resonator.

6. The apparatus (100) as claimed in claim 5, wherein the excitation structure (104) is configured to form a fixed mechanical mode shape during the resonant excitation of the micromirror (102).

7. The apparatus (100) as claimed in any of the previous claims, wherein an amplitude of the sensor signal (122) is proportional to an amplitude of the deflection of the micromirror (102).

8. The apparatus (100) as claimed in any of the previous claims, the apparatus comprising control means (116) configured to provide a control signal (118) for controlling the at least one piezoelectric actuator (106_1:106_n) so that the excitation structure (104) forms a fixed mechanical mode shape.

9. The apparatus (100) as claimed in claim 8, wherein the fixed mechanical mode shape is the second longitudinal mode.

10. The apparatus (100) as claimed in any of the previous claims, the apparatus comprising evaluating means (120) configured to evaluate the sensor signal (122) and to determine the current deflection of the micromirror (102) on the basis of the fixed phase relationship.

11. A method (200) of producing an apparatus as claimed in claim 1, the method including the following steps:
providing (204) a semiconductor substrate;
applying (206) an insulating layer on the semiconductor substrate;
applying (208) a piezoelectric layer on the insulating layer; and
patterning (210) the piezoelectric layer, the insulating layer, and the semiconductor substrate so that the micromirror (102) results and the excitation structure (104) results which supports the micromirror (102) and comprises at least the one piezoelectric actuator (106_1:106_n) to resonantly excite the micromirror (102) so as to cause a deflection of the micromirror (102), the excitation structure (104) comprising a spring structure (130) supporting the micromirror (102), the excitation structure (104) comprising two piezoelectric actuators (106_1, 106_2), and the spring structure (130) being arranged between the two piezoelectric actuators (106_1, 106_2) and being connected to the at least two piezoelectric actuators (106_1:106_n); and so that at least one piezoelectric sensor (108_1:108 _m) for providing a sensor signal (122) dependent on the deflection of the micromirror (102) results, the piezoelectric sensor (108_1:108_m) being connected to the excitation structure (104) so that, during the resonant excitation of the micromirror (102), the sensor signal (122) and the deflection of the micromirror (102) exhibit a fixed mutual phase relationship, the at least one piezoelectric sensor (108_1:108_m) being connected to the spring structure (130) so as to move along with the spring structure (130), the at least one piezoelectric sensor (108_1:108_m) extending at least partially across the spring structure 130;
the spring structure (130) being H-shaped,
the micromirror (102) being supported by a crossbar of the H-shaped spring structure (130),
the at least one piezoelectric sensor (108_1:108_m) being connected to at least one longitudinal bar of the H-shaped spring structure (130).

12. A method (300) of operating the apparatus (100) as claimed in claim 1, the method including the following steps:
resonantly exciting (302) the micromirror (102) by means of an excitation structure (104) so as to cause a deflection of the micromirror (102); and
providing (304) a sensor signal (122) dependent on the deflection of the micromirror (102) by means of the piezoelectric sensor (108_1:108_m).

13. A computer program for performing the method as claimed in claim 12 in an apparatus as claimed in claim 1 when the computer program is executed on a computer or microprocessor.

## Revendications

1. Appareil (100), aux caractéristiques suivantes:
un micro-miroir (102);
une structure d'excitation (104) qui contient ou porte le micro-miroir (102) et présente au moins un actionneur piézoélectrique (106_1:106_n), où la structure d'excitation (104) est conçue pour exciter le micro-miroir (102) de manière résonante pour provoquer une déviation du micro-miroir (102); et
au moins un capteur piézoélectrique (108_1:108_m) destiné à fournir un signal de capteur (122) dépendant de la déviation du micro-miroir (102), où le capteur piézoélectrique (108_1:108_m) est connecté mécaniquement à la structure d'excitation (104), de sorte que, lors de l'excitation résonante du micro-miroir (102), le signal de capteur (122) et la déviation du micro-miroir (102) présentent un rapport de phase fixe entre eux;
dans lequel la structure d'excitation (104) présente une structure de ressort (130) qui porte le micro-miroir (102);
dans lequel la structure d'excitation (104) présente deux actionneurs piézoélectriques (106_1, 106_2), et dans lequel la structure de ressort (130) est disposée entre les deux actionneurs piézoélectriques (106_1, 106_2) et est connectée aux deux actionneurs piézoélectriques (106_1, 106_2); et
dans lequel l'au moins un capteur piézoélectrique (108_1:108_m) est connecté à la structure de ressort (130) pour se déplacer ensemble avec la structure de ressort (130);
dans lequel l'au moins un capteur piézoélectrique (108_1: 108_m) s'étend au moins partiellement sur la structure de ressort (130);
dans lequel la structure de ressort (130) est en forme de "H",
dans lequel le micro-miroir (102) est porté par un support transversal de la structure de ressort en forme de "H" (130),
dans lequel l'au moins un capteur piézoélectrique (108_1:108_m) est connecté à au moins un support longitudinal de la structure de ressort en forme de "H" (130).

2. Dispositif (100) selon l'une des revendications précédentes, dans lequel l'au moins un capteur piézoélectrique (108_1:108_m) est connecté à la structure d'excitation (104) pour se déplacer ensemble avec la structure d'excitation (104),

3. Dispositif (100) selon l'une des revendications précédentes, dans lequel le capteur piézoélectrique (108_1: 108_m) est complètement isolé électriquement de l'au moins un actionneur piézoélectrique (106_1: 106_n).

4. Dispositif (100) selon l'une des revendications précédentes, dans lequel la structure d'excitation (104) est symétrique à l'axe à un axe de torsion du micro-miroir (102), dans lequel le micro-miroir (102) peut être dévié autour de l'axe de torsion.

5. Dispositif (100) selon l'une des revendications précédentes, dans lequel la structure d'excitation (104) est conçue en forme de résonateur.

6. Dispositif (100) selon la revendication 5, dans lequel la structure d'excitation (104) est conçue de manière à constituer une forme de mode mécanique fixe lors de l'excitation résonnante du micro-miroir (102).

7. Dispositif (100) selon l'une des revendications précédentes, dans lequel une amplitude du signal de capteur (122) est proportionnelle à une amplitude de la déviation du micro-miroir (102).

8. Dispositif (100) selon l'une des revendications précédentes, dans lequel le dispositif comporte un dispositif de commande (116) qui est conçu pour fournir un signal de commande (118) pour piloter l'au moins un actionneur piézoélectrique (106_1: 106_n), de sorte que la structure d'excitation (104) constitue une forme de mode mécanique fixe.

9. Dispositif (100) selon la revendication 8, dans lequel la forme de mode mécanique fixe est le deuxième mode longitudinal.

10. Dispositif (100) selon l'une des revendications précédentes, dans lequel le dispositif comporte un dispositif d'évaluation (120) qui est conçu pour évaluer le signal du capteur (122) et pour déterminer la déviation momentanée du micro-miroir (102) sur base du rapport de phase fixe.

11. Procédé (200) de fabrication d'un dispositif selon la revendication 1, dans lequel le procédé comporte les étapes suivantes consistant à:
prévoir (204) un substrat semi-conducteur;
appliquer (206) une couche isolante sur le substrat semi-conducteur;
appliquer (208) une couche piézoélectrique sur la couche isolante; et
structurer (210) la couche piézoélectrique, la couche isolante et le substrat semi-conducteur de sorte que soit créé le micro-miroir (102) et que soit créée la structure d'excitation (104) qui porte le micro-miroir (102) et présente au moins l'un actionneur piézoélectrique (106_1:106_n), pour exciter de manière résonante le micro-miroir (102) pour provoquer une déviation du micro-miroir (102), où la structure d'excitation (104) présente une structure de ressort (130) qui porte le micro-miroir (102), où la structure d'excitation (104) présente deux actionneurs piézoélectriques (106_1, 106_2), et où la structure de ressort (130) est disposée entre les deux actionneurs piézoélectriques (106_1, 106_2) et est connectée aux deux actionneurs piézoélectriques (106_1, 106_2); et de sorte que soit créé au moins un capteur piézoélectrique (108_1:108_m) destiné à fournir un signal de capteur (122) dépendant de la déviation du micro-miroir (102), où le capteur piézoélectrique (108_1:108_m) est connecté à la structure d'excitation (104), de sorte que le signal de capteur (122) et la déviation du micro-miroir (102) présentent, lors de l'excitation résonante du micro-miroir (102), un rapport de phase fixe entre eux, où l'au moins un capteur piézoélectrique (108_1:108_m) est connecté à la structure de ressort (130) pour se déplacer ensemble avec la structure de ressort (130), où l'au moins un capteur piézoélectrique (108_1: 108_m) s'étend au moins partiellement sur la structure de ressort (130);
dans lequel la structure de ressort (130) est en forme de "H",
dans lequel le micro-miroir (102) est porté par un support transversal de la structure de ressort en forme de "H" (130),
dans lequel l'au moins un capteur piézoélectrique (108_1:108_m) est connecté à au moins un support longitudinal de la structure de ressort en forme de "H" (130).

12. Procédé (300) permettant de faire fonctionner le dispositif (100) selon la revendication 1, dans lequel le procédé (300) présente les étapes suivantes consistant à:
exciter de manière résonante (302) le micro-miroir (102) au moyen de la structure d'excitation (104) pour provoquer une déviation du micro-miroir (102); et
fournir (304) un signal de capteur (122) dépendant de la déviation du micro-miroir (102) au moyen du capteur piézoélectrique (108_1:108_m) .

13. Programme d'ordinateur pour la mise en oeuvre du procédé selon la revendication 12 dans un dispositif selon la revendication 1 lorsque le programme d'ordinateur est exécuté sur un ordinateur ou un microprocesseur.
